# EUROPEAN PATENT SPECIFICATION

(11) **EP 3 392 371 B1**
(45) Date of publication and mention of the grant of the patent: **03.11.2021**
(21) Application number: 17167150.6
(22) Date of filing: 19.04.2017
(51) Int. Cl.: C23C 14/50, H01L 21/68, B25B 5/00

(54) **A TOOL FOR FIXING SUBSTRATES IN A PVD PROCESS**
WERKZEUG ZUR FIXIERUNG VON SUBSTRATEN IN EINEM PVD-VERFAHREN
OUTIL DE FIXATION DE SUBSTRATS DANS UN PROCÉDÉ DE DÉPÔT PHYSIQUE EN PHASE VAPEUR

(43) Date of publication of application: 24.10.2018
(73) Proprietor: Vestel Elektronik Sanayi ve Ticaret A.S., 45030 Manisa (TR)
(72) Inventor: KUYUCU, Ömer Gökce, 45030 Manisa (TR)
(74) Representative: Kehl, Ascherl, Liebhoff & Ettmayr Patentanwälte Partnerschaft mbB

(56) References cited:
- EP-A1- 1 054 439
- DE-A1- 4 232 902
- US-A- 5 168 168
- US-A- 5 325 812

## Description

This invention refers to a tool for fixing a substrate to a satellite in a PVD (Physical Vapor Deposition) processing unit according to claim 1.

### Background of the Invention

Generally, a PVD (Physical vapor deposition) system is utilized for depositing a thin layer of coating over a predefined surface/ substrate in an inert atmosphere. A target material is selected based on the required coating over the substrate. Different types of PVD systems are available, and in that, magnetron sputtering is one type of PVD. Magnetron sputtering is used to deposit thin films of plastics over a substrate. Further, this process is carried out in a vacuum or low-pressure environment. A magnetic field is used to concentrate high-energy ions onto a coating target in order to eject atoms. Magnetron sputtering is a powerful, flexible and material-independent coating process, which can be used to coat most common surfaces with a variety of materials. The high-energy atoms can penetrate into the substrate to create uniform and tight patterns that improve the durability and performance of the surface of the substrate.

The magnetron sputtering system utilizes electrical energy to create high-energy plasma ions in a vacuum. Further, the magnetron provides a magnetic field that concentrates the ions onto the target (cathode). As the ions strike the target, neutral atoms, molecules and secondary electrons are emitted (sputtering). The ejected atoms move towards the substrate and they condense to form a thin film of the coating material. The secondary electrons may collide with the inert gas in the chamber and can help to maintain the plasma. The plasma, in the conventional magnetron sputtering method, is concentrated above the target and might cause ions to bombard and affect the corresponding film on the substrate.

Conversely, this is eliminated in the unbalanced magnetron sputtering method; wherein the magnetic field is arranged in a way to spread the plasma. This helps to maintain a low ion concentration near the substrate. In this apparatus, effective area parts (substrate parts under the magnetic field) are assembled on to a fixture called a satellite. Usually, the satellite is designed with respect to the dimensions and the shape of the parts/ substrate that need to be coated.

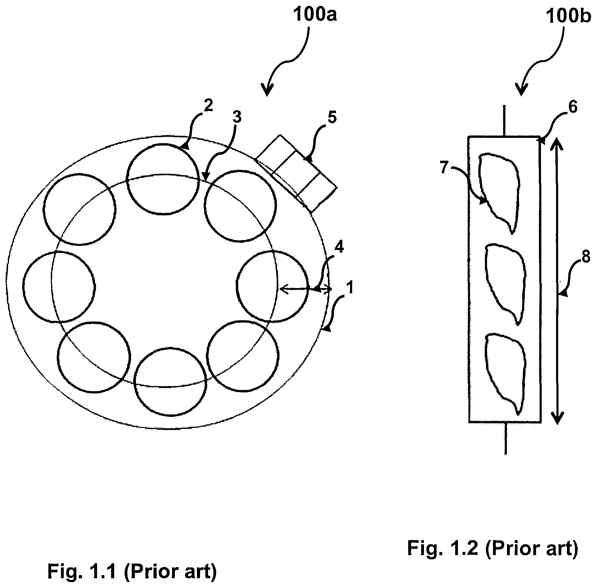

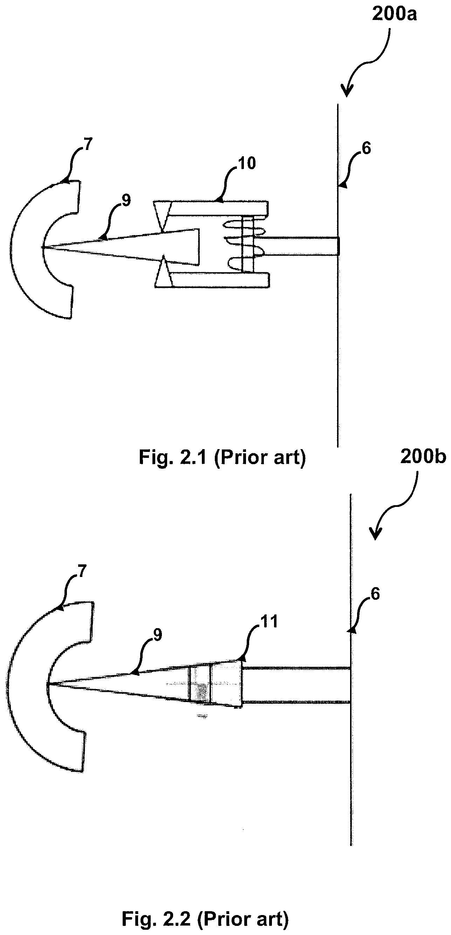

Some difficulties occur while fixing the substrate on to the satellite / fixture for coating. In particular, the substrate/ part may rotate inside the vacuum room at a high speed as depicted in figure 1.1 and figure 1.2. Further, many of the systems use two orbit rotations that are: satellite first turning orbit 2 and satellite second turning orbit 3, to obtain higher coating efficiency. Figure 2.1 and figure 2.2 depict two fixing models for the satellite 6. One is to leave some runner of plastic mould 9 and fixing it with a spring supported jaw 10 (type-1) or screwing it with a spring screw (type-2) and nut connector 11 holes, as respectively shown in figure 2.1 and figure 2.2.

In the spring supported jaw fixing method, the runner of plastic mould 9 projects out from the moulding tool and that leads to coating unwanted parts because of the fixing. Another problem with the spring supported jaw 10 and fixing screw along with nut connector 11 is that the fixtures may also stay in the effective magnetic area 4 and also can be coated as shown in figure 1.1 and figure 1.2. In some processing cycles, the spring may get blocked and the jaw 10 that is supported by the spring may get stuck. Further, the jaw 10 cannot press on to the parts/ substrates. Consequently, the jaw and the spring need to be changed or cleaned. In the other method of fixing the substrate on to the satellite using the fixing screw and nut connector 11, the fixing process itself may consume more time. Further, the fixing method requires skilled labor and that leads to an increase in labor cost. Usually the performance of PVD vacuum coating systems is determined based on an adjustment mechanism for rotating/turning a substrate that needs to be coated and the substrate fixing time. Further, the performance of the PVD is determined by the flexibility of the system to coat differently structured / shaped parts that need to be coated. To solve these problems, there exists a need to develop a flexible fixing system without a need for a cleaning requirement in PVD satellites.

The prior art US 5334302 A is related to a magnetron sputtering apparatus and sputtering gun for use in the same. This prior art includes a vacuum chamber, multiple spray guns for spraying the coating material in plasma form, building support pieces, target surfaces that need to be coated with the coating material, cooling blocks, a magnetron atomizer and so on. Further, the target surfaces are connected to the cooling blocks by means of a clamp bracket and said clamp bracket is mounted to the cooling block by means of pins. Further, this prior art discloses a mounting device comprising a pin and a clamp for mounting on a cooling block, which serves as a satellite part of a target surface used as a substrate for use in magnetron spraying systems. But this prior art does not contain features for compressing base sheet parts with different squeeze grades.

In another prior art document WO 02/070777 A1, a rotating cathode for use in magnetron sputtering systems includes a method and apparatus for mounting a target on a flange-supported shaft. Said apparatus assists in the application of higher torque to the target by accelerating the installation of the target in the system, reducing the heat loss between the shaft and the target, and equalizing the pressure distribution applied during coupling of the shaft and the target. Said mounting bracket consists of angular rings and discrete clamp arms. Said discrete clamp arms are concentric with the target and are angularly rotatable. WO 021070777 A1 discloses a mounting arrangement for use in magnetron sputtering systems, which is used for connecting the rotary shaft of the target material and includes clamp pieces which rotate coaxially with the target. However, it is preferred that said mounting apparatus is capable of performing at least two circular axial turning motions and operating at different power ratings. It does not contain any explanation as to whether the substrate parts can be compressed.

The prior art US 5800687 A discloses a coating system for coating CD-like flat materials. The system comprises a spray catheter; a mask used to cover only the exposed portions of the underlying layer to be coated thereon; inner and outer guide elements providing the rotational movement of a mantle and two circular flanges. The two circular flanges provided in a closed system in a vacuum environment are connected to two clamp pieces as two axles. US 5800687 A does not provide any explanation as to the ability to carry out at least two circular axial rotational movements and to work with different strength grades so that the substrate parts having different hardness grades can be compacted.

The subject-matter of the prior art described so far does not have the ability to perform at least two circular axial turning motions and to work with different strength/ squeeze grades so that substrates/ parts having different hardness grades can be compressed.

EP 1 054 439 A1 describes a gripper assembly which supports a substrate in a vertical orientation. The gripper assembly's end effectors contact only the edge of the substrate. The end effectors each comprise a first pair or opposed surfaces and an second pair of opposed surfaces, all of which simultaneously contact the substrate, holding the substrate in a clamp-type manner. The fingers to which the end effectors are coupled, are bent so that the gripper is not positioned above the substrate.

US 5 168 168 A describes a holder for centered round articles, which comprises a frame having a first arm and a second arm pivotally attached thereto. The first arm defines a single contact point at its distal end while the second arm defines a pair of diverging surfaces at its distal end. The two arms are mechanically coupled to rotate relative to each other in a fixed relationship, and the curved surfaces on the second arm are shaped in a particular manner so that circular articles held by the two arms will be centered at a fixed location relative to the frame.

DE 42 32 902 A1 describes a holder for flat disc-shaped substrates in a vacuum processing installation, which has two identical elastic holding fingers. The holding fingers lie in the substrate plane; are diametrically opposite to one another, and point towards the substrate midpoint; the enclosed angle lies preferably between 25 and 120 deg.; the fingers of each pair are rigidly joined to one another; the joining points lie on a straight line passing through the midpoint; the direction of motion of the clamping elements is approximately parallel to this straight line.

### Object of the Invention

It is therefore an object of the present invention to provide a device, in particular a tool for fixing substrates in a PVD process to perform at least two circular axial turning motions and to work with different strength/ squeeze grades to get better efficiency compared to the known devices.

### Description of the Invention

The before mentioned object is solved by a tool for fixing a substrate to a satellite in a PVD process according to claim 1.

This solution is beneficial since the forcing structure can enable the substrate to rotate in two circular axial turning motions. Further, the tool can work with different strength/ squeeze grades to get better efficiency, that is, better coating over the substrate material.

Further preferred embodiments are the subject-matter of the dependent claims and/or of the following specification parts.

According to a preferred embodiment of the present invention, the squeezing force direction or tension of the squeezing of the substrate is determined by the distance between the two or more non-coaxial axis holes in which the respective second ends of the connection pins of the clamp are fixed. Different distances between each pair of the two or more non-coaxial axis holes may aid to fix different parts to the tool with different squeeze levels. The tool can be capable of working at different force levels by setting the forcing structure at different force levels. Further, the tool is capable of use with any part of the substrate. The part of the substrate can includes a circular, rectangular, triangular or any uneven part. The forcing structure is adapted to be used with different clamps.

Further benefits, goals and features of the present invention will be described by the following specification of the attached figures, in which components of the invention are exemplarily illustrated. Components of the devices and method according to the invention, which match at least essentially with respect to their function can be marked with the same reference sign, wherein such components do not have to be marked or described in all figures.

The invention is just exemplarily described with respect to the attached figures in the following.

### Brief Description of the Drawings

- Fig. 1.1: illustrates a top view of a vacuum chamber of a PVD processing unit according to the prior art;
- Fig. 1.2: illustrates a position of the substrate and satellite of the PVD processing unit according to the prior art;
- Fig. 2.1: illustrates a side view of a conventional fixture tool of type-1 for fixing a substrate in the PVD processing unit according to the prior art;
- Fig. 2.2: illustrates a side view of a conventional fixture tool of type-2 for fixing a substrate in the PVD processing unit according to the prior art;
- Fig. 3: illustrates a tool for fixing a substrate in a PVD processing unit according to an embodiment of the present invention; and
- Fig. 4: illustrates possible positions of the connection pins in the non-coaxial axis holes of the tool, according to the embodiment of the present invention.

### Detailed Description of the Drawings

Fig. 1.1 illustrates a top view 100a of a vacuum chamber 1 of a PVD processing unit according to the prior art. According to this prior art, the vacuum chamber 1 utilizes two orbit rotations, that are: satellite 6 first turning orbit 2 and satellite 6 second turning orbit 3, to obtain higher coating efficiency. The second turning orbit 3 of satellite 6 makes the substrate 7 move near to a target 5 that is the coating material. The effective area of coating region 4 is less compared to the exposed substrate 7.

Fig. 1.2 illustrates a position 100b of the substrate 7 and satellite 6 in the PVD processing unit according to the prior art. The substrate 7 materials are placed over the satellite 6 to perform the coating process using PVD. The effective coating height 8 of the PVD can be decided based on the satellite.

Fig. 2.1 and Fig. 2.2 respectively illustrate side views of conventional fixture tools of type-1 200a and type-2 200b for fixing substrate 7 in the PVD processing unit according to the prior art. The two fixing models for fixing the substrate 7 over the satellites 6 are depicted in figure 2.1 and figure 2.2. Figure 2.1 illustrates a satellite 6 that has a runner of plastic mould 9. The runner of plastic mould 9 is supported by a jaw 10 (type-1). Figure 2.2 illustrates a runner of plastic mould 9 that is fixed by screwing it with a spring screw (type-2) and nut connector 11 holes.

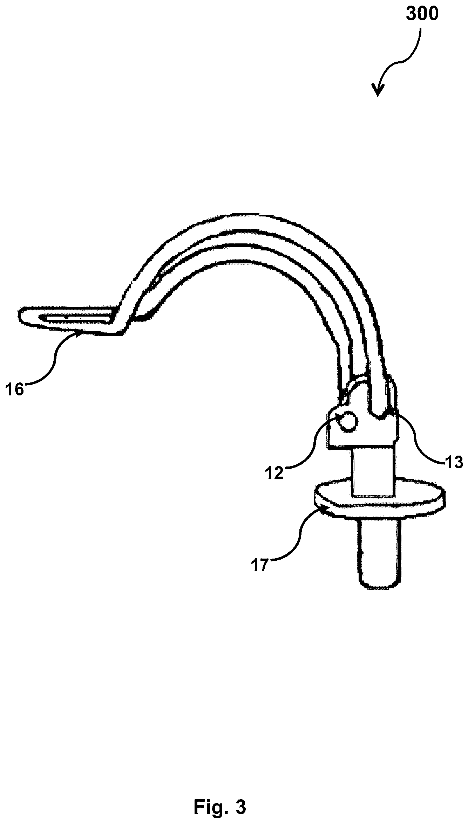

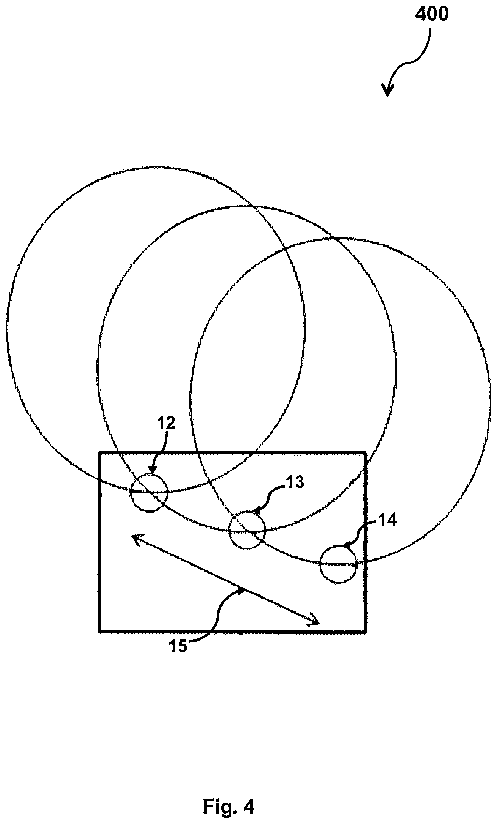

Fig. 3 illustrates a tool 300 for fixing substrates 7 in a PVD processing unit according to an embodiment of the present invention. The tool for fixing a substrate 7 to a satellite 6 in a PVD process according to the present invention can include a clamp 16, at least two connecting means and a forcing structure 17. The clamp 16 can include at least two connection pins and a head which joins the at least two connection pins to each other at a respective first end of each of said connection pins, as shown in Fig. 3. The two connecting means can be provided with two or more non-coaxial axis holes 12, 13 & 14 (shown in figure 4), each for receiving a respective second end of one of the connection pins remote from the respective first end thereof. The forcing structure 17 can be provided to control a squeeze force on the substrate 6. The head of the clamp 16 can be provided to hold the substrate 7. The connection pins of the clamp 16 can be fixed in the non-coaxial axis holes 12 & 13, thereby making a squeeze force on the substrate 7 for coating. One end of the forcing structure 17 can be connected to the connecting means and another end may be connected to the satellite 6. The tool can be used for fixing plastic substrates 7 for coating. The performance or usage of this tool may not affect the coating and also solves the problem of time consumption. The forcing structure 17 is capable of being used with different clamps 16. Hence, the tool can be used for any part of the substrate 7. The part of the substrate 7 includes a circular, rectangular, triangular or any uneven part. The substrate material may include, but is not limited to, polymeric material, and so on.

Fig. 4 illustrates possible positions 400 of the connection pins in the non-coaxial axis holes 12, 13 & 14 of the tool, according to the embodiment of the present invention. The possible positions of the connection pins of the clamp 16 that can be fixed in the non-coaxial axis holes 12, 13 & 14 of the tool is illustrated for three non-coaxial axis holes 12, 13 & 14 in the connecting means. Any two of the three non-coaxial axis holes 12, 13 & 14 can be connected to obtain the squeezing force. The squeezing force direction 15 or tension of the squeezing of the substrate is determined by the distance between the two or more non-coaxial axis holes in which the ends of the connection pins of the clamp 16 are fixed. The distances between the two or more non-coaxial axis holes 12, 13 & 14 may aid fixing different parts with different squeeze levels. The tool can work at different force levels by setting the forcing structure 17 at different force levels.

According to a preferred embodiment of the present invention, one squeezing tool can work with different part (substrate) shapes. Further, the need for different satellites 6 for adjusting the squeezing force can be eliminated by use of the tool. The rough design of the tool may not affect the PVD coating. In addition to that, the lesser process cycle time for loading and unloading of parts reduces the overall coating process time.

Thus, the present invention refers to a tool for fixing a substrate to a satellite in a PVD process. The tool for fixing the substrate 7 to the satellite 6 in a PVD process performs at least two circular axial turning motions and works with different strength/ squeeze grades to get better coating efficiency. The tool preferably comprises a clamp 16, at least two connecting means and a forcing structure 17. The clamp 16 may include at least two connection pins and a head. The forcing structure 17 can be provided to control a squeeze force on the substrate 7. The connection pins of the clamp 16 can be fixed in non-coaxial axis holes 12, 13 that may be provided in the connecting means, thereby making a squeeze force on the substrate 7 for coating. One end of the forcing structure 17 can be connected to the connecting means and another end may be connected to the satellite 6.

### List of reference numbers

- 1: vacuum chamber of PVD
- 2: satellite first turning orbit
- 3: satellite second turning orbit
- 4: effective coating region
- 5: target (coating material) of the magnetron sputtering unit (or PVD)
- 6: satellite
- 7: substrate for coating
- 8: effective coating height
- 9: runner of plastic mold
- 10: spring supported jaw
- 11: fixing screw and nut connector
- 12: non-coaxial first axis hole
- 13: non-coaxial second axis hole
- 14: non-coaxial third axis hole
- 15: squeeze forcing direction
- 16: non-coaxial clamp
- 17: forcing structure
- 100a: top view of vacuum chamber
- 100b: the position of the substrate and satellite
- 200a: side view of conventional fixture tool of type-1
- 200b: side view of conventional fixture tool of type-2
- 300: tool for fixing substrates in a PVD processing unit
- 400: possible positions of connection pins in the non-coaxial axis holes of the tool

## Claims

1. A tool for fixing a substrate (7) to a satellite (6) in a PVD process, wherein the tool comprises:
a clamp (16) comprising at least two connection pins and a head joining the at least two connection pins to each other at a respective first end of each of said connection pins;
at least two connecting means comprising two or more non-coaxial axis holes (12,13), each for receiving a respective second end of one of the connection pins remote from the respective first end thereof;
a forcing structure (17) configured to control a squeezing force on the substrate (7); wherein the clamp (16) is configured to hold the substrate (7);
wherein the respective second ends of the connection pins of the clamp (16) are fixed in said non-coaxial axis holes (12,13), thereby making the squeezing force on the substrate (7) for coating; and
wherein one end of the forcing structure (17) is connected to the connecting means and another end is connected to the satellite (6).

2. The tool of claim 1, wherein the squeezing force direction (15) or tension of the squeezing of the substrate (7) is determined by the distance between the two or more non-coaxial axis holes (12,13) in which the respective second ends of the connection pins of the clamp (16) are fixed.

3. The tool of claim 1, wherein different distances between each pair of the two or more non-coaxial axis holes (12, 13) help to fix different parts to the tool with different squeeze levels.

4. The tool of claim 1, wherein the tool is capable of working at different force levels by setting the forcing structure (17) at different force levels.

5. The tool of claim 1, wherein the tool is capable of use with any part of the substrate (7).

6. The tool of claim 5, wherein the part of the substrate (7) comprises a circular, rectangular, triangular or any uneven part.

7. The tool of claim 1, wherein the forcing structure (17) is adapted to be used with different clamps (16).

## Patentansprüche

1. Werkzeug zum Befestigen eines Substrats (7) an einem Satelliten (6) in einem PVD-Verfahren, wobei das Werkzeug aufweist:
eine Klemme (16), die mindestens zwei Verbindungsstifte und einen Kopf aufweist, der die mindestens zwei Verbindungsstifte an einem jeweiligen ersten Ende jedes der Verbindungsstifte miteinander verbindet;
mindestens zwei Verbindungsmittel, die zwei oder mehr nicht-koaxiale Achsenlöcher (12, 13) aufweisen, von denen jedes zur Aufnahme eines jeweiligen zweiten Endes eines der Verbindungsstifte entfernt von dessen jeweiligem ersten Ende dient;
eine Druckstruktur (17), die so konfiguriert ist, dass sie eine Quetschkraft auf das Substrat (7) steuert
wobei die Klemme (16) so konfiguriert ist, dass sie das Substrat (7) hält;
wobei die jeweiligen zweiten Enden der Verbindungsstifte der Klemme (16) in den nicht-koaxialen Achsenlöchern (12, 13) befestigt sind, wodurch die Druckkraft auf das Substrat (7) zum Beschichten erzeugt wird; und
wobei ein Ende der Druckstruktur (17) mit dem Verbindungsmittel verbunden ist und ein anderes Ende mit dem Satelliten (6) verbunden ist.

2. Werkzeug nach Anspruch 1, wobei die Richtung der Quetschkraft (15) oder die Spannung des Quetschens des Substrats (7) durch den Abstand zwischen den zwei oder mehr nichtkoaxialen Achsenlöchern (12, 13) bestimmt wird, in denen die jeweiligen zweiten Enden der Verbindungsstifte der Klemme (16) befestigt sind.

3. Werkzeug nach Anspruch 1, wobei unterschiedliche Abstände zwischen jedem Paar der zwei oder mehr nicht-koaxialen Achslöcher (12, 13) dazu beitragen, verschiedene Teile mit unterschiedlichen Druckstufen an dem Werkzeug zu befestigen.

4. Werkzeug nach Anspruch 1, wobei das Werkzeug in der Lage ist, bei unterschiedlichen Kraftniveaus zu arbeiten, indem die Druckstruktur (17) auf unterschiedliche Kraftniveaus eingestellt wird.

5. Werkzeug nach Anspruch 1, wobei das Werkzeug mit jedem Teil des Substrats (7) verwendet werden kann.

6. Werkzeug nach Anspruch 5, wobei der Teil des Substrats (7) ein kreisförmiges, rechteckiges, dreieckiges oder ein beliebiges unebenes Teil aufweist.

7. Das Werkzeug nach Anspruch 1, wobei die Zwangsstruktur (17) so angepasst ist, dass sie mit verschiedenen Klemmen (16) verwendet werden kann.

## Revendications

1. Outil pour fixer un substrat (7) à un satellite (6) dans un procédé PVD, dans lequel l'outil comprend :
une pince (16) comprenant au moins deux broches de connexion bras similaires et une tête joignant les au moins deux broches de connexion bras l'une à l'autre à une première extrémité respective de chacune desdites broches de connexion bras ;
au moins deux moyens de connexion comprenant deux ou plusieurs trous d'axe non coaxial (12, 13), chacun pour recevoir une seconde extrémité respective de l'une des broches de connexion de bras éloignée de la première extrémité respective de celle-ci ;
une structure de forçage (17) configurée pour contrôler une force d'écrasement sur le substrat (7) en forçant les bras à s'écarter latéralement ;
dans lequel la pince (16) est configurée pour maintenir le substrat (7) ;
dans lequel les secondes extrémités respectives des broches de connexion des bras de la pince (16) sont fixées dans lesdits trous d'axe non coaxial (12, 13), rendant ainsi la force d'écrasement sur le substrat (7) pour le revêtement ; et
dans lequel une extrémité de la structure de forçage (17) est reliée au moyen de connexion et une autre extrémité est reliée au satellite (6).

2. L'outil de la revendication 1, dans lequel la direction de la force d'écrasement (15) ou la tension de l'écrasement du substrat (7) est déterminée par la distance entre les deux ou plusieurs trous d'axe non coaxial (12, 13) dans lesquels les secondes extrémités respectives des broches de connexion des bras de la pince (16) sont fixées.

3. L'outil de la revendication 1, dans lequel les différentes distances entre chaque paire de deux ou plusieurs trous d'axe non coaxial (12, 13) aident à fixer différentes parties à l'outil avec différents niveaux d'écrasement.

4. L'outil de la revendication 1, dans lequel l'outil est capable de travailler à différents niveaux de force en réglant la structure de forçage (17) à différents niveaux de force.

5. L'outil de la revendication 1, dans lequel l'outil est capable d'être utilisé avec n'importe quelle partie du substrat (7).

6. L'outil de la revendication 5, dans lequel la partie du substrat (7) comprend une partie circulaire, rectangulaire, triangulaire ou toute partie irrégulière.

7. L'outil de la revendication 1, dans lequel la structure de forçage (17) est adaptée pour être utilisée avec différentes pinces (16).
